# FASCICULE DE BREVET EUROPEEN

(11) **EP 3 273 147 B1**
(45) Date de publication et mention de la délivrance du brevet: **18.08.2021**
(21) Numéro de dépôt: 17181639.0
(22) Date de dépôt: 17.07.2017
(51) Int. Cl.: F21S 41/141, F21S 43/14, F21S 45/47, H01L 33/64, H01L 25/075, H01L 25/16, H01L 33/08, H01L 33/24

(54) **MODULE LUMINEUX DE VEHICULE TERRESTRE**
LEUCHTMODUL EINES LANDFAHRZEUGS
LAND VEHICLE LIGHT MODULE

(30) Priorité: 22.07.2016 FR 1657040
(43) Date de publication de la demande: 24.01.2018
(73) Titulaire: Valeo Vision, 93012 Bobigny Cedex (FR)
(72) Inventeur: SEIF, Lothar, 93012 Bobigny Cedex (FR); ROUCOULES, Christine, 93012 Bobigny Cedex (FR); BRIAND, Gilles, 93012 Bobigny Cedex (FR); REISS, Benoit, 93012 Bobigny Cedex (FR); ZOJCESKI, Zdravko, 93012 Bobigny Cedex (FR)

(56) Documents cités:
- EP-A2- 2 390 930
- WO-A1-2010/014032
- US-A1- 2011 157 897
- US-A1- 2013 048 945
- US-A1- 2013 049 040
- US-A1- 2014 125 213
- US-A1- 2016 064 607

## Description

### DOMAINE DE L'INVENTION

L'invention se rapporte au domaine des modules lumineux de véhicule terrestre, c'est-à-dire des modules pouvant être intégrés à un dispositif lumineux du véhicule et permettant, lors de l'utilisation du véhicule, de projeter de la lumière éclairant la route ou l'habitacle et/ou permettant au véhicule de se rendre plus visible. Des exemples de tels dispositifs lumineux sont les feux de position ou les feux de croisement et/ou route (communément appelés « phares »).

### ARRIERE-PLAN

Un véhicule terrestre est équipé de dispositifs lumineux, notamment d'éclairage et/ou de signalisation, tels que des projecteurs avants ou feux arrières, destinés à illuminer la route devant le véhicule, la nuit ou en cas de luminosité réduite. Ils peuvent aussi servir à éclairer l'habitacle du véhicule. Ces dispositifs lumineux peuvent comprendre un ou plusieurs modules lumineux. Chaque fonction d'éclairage peut être assurée par un ou des module(s). Par ailleurs, dans ces modules lumineux de véhicules terrestres, les sources de lumière sont de plus en plus fréquemment constituées par des diodes électroluminescentes ou LEDs (acronyme anglosaxon pour « Light Emitting Diode »), notamment pour des avantages d'encombrement et de durée de vie par rapport à des sources de lumière classiques.

La technologie LED implique toutefois une gestion spécifique de la chaleur générée par les différents composants du module lumineux. En effet, la chaleur générée entraîne une élévation de la température au niveau des composants qui peut dégrader les composants et/ou en empêcher une utilisation optimale.

Les solutions existantes pour gérer cette chaleur ne sont pas optimales pour des puissances dissipées élevées, notamment supérieures à 25W, dans un module lumineux. Par exemple, les solutions existantes présentent généralement différents inconvénients au niveau du module lumineux et/ou d'un dispositif lumineux intégrant le module lumineux. Ces inconvénients peuvent inclure un relatif encombrement par les pièces nécessaires à la gestion de la chaleur pour assurer le refroidissement et la performance optique, que ce soit en refroidissement par convection naturel ou forcée, et/ou une fabrication relativement longue, compliquée, et/ou coûteuse.

Le document US2016064607A1 divulgue un projecteur de véhicule comprenant une source lumineuse avec des éléments émetteurs à nanostructure montée sur un radiateur pour la refroidir.

### RESUME DE L'INVENTION

On propose donc un module lumineux de véhicule terrestre comprenant au moins une source lumineuse à semi-conducteur comportant un substrat. Le substrat est majoritairement en matériau semi-conducteur. Le substrat présente une première face et une deuxième face. La source lumineuse comporte en outre des éléments électroluminescents de dimensions submillimétriques s'étendant à partir de la première face du substrat. Le module comprend également au moins un dissipateur thermique coopérant avec la deuxième face du substrat de manière à évacuer la chaleur produite par la source lumineuse. Le substrat est alimenté en électricité par un circuit imprimé, le circuit imprimé contournant le substrat. Le dissipateur thermique est agencé contre la deuxième face du substrat via un élément intermédiaire qui comprend un ou plusieurs dispositifs électronique.

Selon différents modes de réalisation, le module lumineux peut comprendre l'une ou plusieurs des caractéristiques suivantes combinées entre elles :
- les éléments électroluminescents présentent une forme de bâtonnet ;
- les bâtonnets s'étendent orthogonalement au substrat ;
- les bâtonnets présentent une forme générale cylindrique, notamment de section polygonale ;
- chaque bâtonnet présente un diamètre compris entre 0.5 µm et 2.0 µm, préférentiellement 1 µm ;
- chaque bâtonnet présente une hauteur comprise entre 1 µm et 10 µm préférentiellement 8 µm ;
- la distance entre deux bâtonnets immédiatement adjacents est comprise entre 3 µm et 10 µm ;
- la distance entre deux bâtonnets immédiatement adjacents est constante ou variable ;
- la luminance des bâtonnets est d'au moins 60 Cd/mm², de préférence d'au moins 80 Cd/mm² ;
- les bâtonnets sont agencés pour émettre des rayons lumineux le long du bâtonnet (c'est-à-dire le long d'une direction perpendiculaire à un plan majoritaire d'extension du substrat) et en bout de celui-ci ;
- la première face et la deuxième face sont sensiblement parallèles entre elles ;
- le matériau semi-conducteur comporte du silicium ;
- les éléments électroluminescents sont répartis dans différentes zones d'émission lumineuse activables sélectivement ;
- le substrat est alimenté en électricité par un circuit imprimé directement ou via une pièce intermédiaire alimentée en électricité par le circuit imprimé et alimentant le substrat en électricité ;
- la pièce intermédiaire est alimentée par le circuit imprimé directement ;
- la pièce électrique est le dispositif électronique apte à commander les éléments électroluminescents ;
- le substrat est alimenté en électricité par le circuit imprimé via un câblage par fil ;
- le câblage par fil est entre le circuit imprimé et le substrat et/ou entre le circuit imprimé et l'intermédiaire électrique ;
- le substrat est alimenté en électricité par le circuit imprimé via une soudure ;
- la soudure est entre le circuit imprimé et le substrat et/ou entre le circuit imprimé et l'intermédiaire électrique ;
- la soudure est sur une couche conductrice du circuit imprimé ;
- le substrat est alimenté en électricité par le circuit imprimé via un dispositif électronique apte à commander les éléments électroluminescents, le module comprenant un câblage par fil entre le circuit imprimé et le dispositif électronique et une soudure entre le dispositif électronique de commande et le substrat ;
- le circuit imprimé est flexible ;
- l'élément intermédiaire forme un pont thermique constitué d'un ensemble d'un ou plusieurs matériaux consécutifs depuis le substrat jusqu'au dissipateur thermique, chaque matériau du pont thermique présentant une conductivité thermique supérieure à 1 W/(m·K) ;
- l'ensemble d'un ou plusieurs matériaux comprend une ou plusieurs pâtes thermiques ;
- l'ensemble d'un ou plusieurs matériaux comprend un ou plusieurs métaux conducteurs électriques ;
- l'ensemble d'un ou plusieurs matériaux comprend le cuivre ;
- l'élément intermédiaire comprend une ou plusieurs couches de pâte thermique ;
- l'élément intermédiaire comprend une ou plusieurs couches de cuivre ;
- l'élément intermédiaire comprend une pâte thermique ;
- la pâte thermique est isolante électriquement ;
- l'élément intermédiaire comprend une couche de cuivre ;
- la couche de cuivre recouvre au moins une partie du dissipateur thermique ;
- la couche de cuivre recouvre au moins une partie de la deuxième face ;
- la source lumineuse est collée ou soudée au dissipateur thermique ;
- la source lumineuse est en contact direct avec le dissipateur thermique ;
- la source lumineuse est en contact avec le dissipateur thermique via l'élément intermédiaire ;
- le module comprend en outre un dispositif électronique apte à commander les éléments électroluminescents ;
- le dispositif électronique comprend au moins un convertisseur de puissance et/ou un circuit intégré ;
- le circuit intégré comprend un ASIC et/ou un ASSP ;
- le dispositif électronique est agencé sur la deuxième face du substrat ;
- l'élément intermédiaire comprend un ou plusieurs dispositifs électroniques de commande, chaque dispositif électronique de commande étant configuré pour commander un ensemble d'éléments semi-conducteurs électroluminescents respectif avec leurs pistes de conducteur électrique respectives pour assurer le fonctionnement ;
- le dissipateur thermique comprend un ou plusieurs radiateurs à ailettes ;
- le dissipateur thermique présente une conductivité thermique supérieure ou égale à 0,2 W/(m.K), de préférence supérieure ou égale à 1 W/(m.K), plus préférentiellement supérieure ou égale à 5 W/(m.K) ;
- le dissipateur thermique comporte du magnésium et/ou de l'aluminium et/ou du cuivre et/ou un polymère thermoconducteur ;
- le dissipateur thermique présente une cavité apte à recevoir au moins le dispositif électronique ;
- la cavité présente un fond ;
- le fond est en contact avec le dissipateur thermique ;
- la cavité est un trou traversant le dissipateur thermique ;
- le dispositif électronique traverse au moins partiellement le dissipateur thermique ;
- comprenant un deuxième dissipateur thermique coopérant avec le dispositif électronique ;
- dans lequel le deuxième dissipateur présente une forme sensiblement complémentaire de la cavité ;
- le dissipateur thermique comprend une plaque ;
- la plaque comprend un premier côté et un deuxième côté ;
- le premier côté coopère avec le substrat et le deuxième côté présente des ailettes de refroidissement ;
- les ailettes de refroidissement font saillie depuis le deuxième côté ;
- le module comprend en outre un système de répartition de chaleur intégré au substrat ;
- le système de répartition de chaleur présente une surface égale ou supérieure à la surface des zones portant les éléments électroluminescents ; et/ou
- le système de répartition de chaleur comprend un ou plusieurs micro-caloducs.

On propose également un dispositif lumineux, notamment d'éclairage et/ou de signalisation de préférence de véhicule terrestre, comprenant au moins un module lumineux tel que proposé ci-dessus.

Le dispositif peut comprendre un premier module lumineux tel que proposé ci-dessus et un deuxième module lumineux tel que proposé ci-dessus, le premier distinct du deuxième.

Le dissipateur thermique du premier module lumineux peut être venu de matière avec le dissipateur thermique du deuxième module lumineux.

Le dispositif peut être configuré pour réaliser une fonction photométrique, notamment réglementaire.

Le dispositif lumineux peut être un projecteur avant de véhicule automobile.

### BREVE DESCRIPTION DES FIGURES

D'autres caractéristiques et avantages de l'invention apparaîtront à la lecture de la description détaillée qui suit de l'invention, donnée à titre d'exemple et en référence aux dessins annexés, dans lesquels :
- La FIG. 1 montre schématiquement un module lumineux selon l'art antérieur ;
- La FIG. 2 représente schématiquement une portion de la source lumineuse d'un exemple de module lumineux selon l'invention ;
- Les FIGs. 3-12 illustrent schématiquement différents exemples de module lumineux et/ou de dispositif lumineux selon l'invention.

### DESCRIPTION DETAILLEE

On propose un module lumineux de véhicule terrestre, ainsi qu'un dispositif lumineux comprenant une ou plusieurs versions d'un tel module lumineux. Le dispositif lumineux peut constituer ou être intégré à un projecteur de lumière. Le dispositif lumineux peut être un projecteur avant, un feu arrière ou un appareil lumineux pour l'habitacle. On propose également un véhicule terrestre comprenant une ou plusieurs versions d'un tel dispositif lumineux (par exemple une ou plusieurs paires de versions à l'avant et/ou une ou plusieurs paires de versions à l'arrière pour un véhicule quatre roues, ou une ou plusieurs versions à l'avant et/ou une ou plusieurs versions à l'arrière pour un véhicule deux ou trois roues).

Le module lumineux comprend au moins une source lumineuse à semi-conducteur comportant un substrat majoritairement en matériau semi-conducteur. On peut ainsi faire référence au substrat par l'expression « substrat semi-conducteur ». Le substrat peut comporter un ou plusieurs autres matériaux, par exemple non semi-conducteurs.

La source lumineuse comporte également un ou plusieurs ensembles d'éléments électroluminescents s'étendant à partir d'une première face du substrat. Par conséquent, le module lumineux comprend au moins une pluralité de tels éléments s'étendant à partir de la première face du substrat. Chaque ensemble est constitué de plusieurs éléments s'étendant à partir d'une portion respective de la première face du substrat. Les éléments électroluminescents peuvent donc être répartis dans différentes zones d'émission lumineuse. Dans un exemple, ces différentes zones peuvent être activables sélectivement. Les éléments peuvent présenter une forme générale de bâtonnet et être ainsi appelés « bâtonnets ».

De même que le substrat, les éléments électroluminescents peuvent être chacun semi-conducteur, c'est-à-dire qu'ils comportent chacun au moins un matériau semi-conducteur. Les éléments électroluminescents peuvent être majoritairement en matériau semi-conducteur. Ce matériau semi-conducteur peut être le même que ou différent du matériau semi-conducteur du substrat. Les éléments électroluminescents peuvent plus généralement être tous réalisés dans le ou les mêmes matériaux. Les éléments électroluminescents peuvent être de même nature, par exemple sensiblement identiques ou similaires. Tous les éléments électroluminescents d'un même ensemble peuvent être parallèles et s'étendre dans la même direction. Tous les ensembles peuvent s'étendre dans la même direction. La direction peut être orthogonale au substrat.

Les éléments sont électroluminescents. Cela signifie qu'ils émettent de la lumière lorsque le matériau des éléments électroluminescents est alimenté en électricité. Les éléments électroluminescents d'un même ensemble peuvent former un groupe coopérant pour réaliser une fonction photométrique. Les éléments électroluminescents peuvent être alimentés en électricité via le substrat d'un côté (e. g. le substrat formant par exemple la cathode) et via une couche de matériau électriquement conducteur qui lie électriquement les éléments électroluminescents entre eux de l'autre côté (e. g. la couche de matériau électriquement conducteur formant par exemple l'anode). Le contact entre le matériau semi-conducteur de chaque élément électroluminescent et le matériau semi-conducteur du substrat peut donc être adapté à une conduction électrique. La couche de matériau électriquement conducteur peut recouvrir les éléments électroluminescents. La couche de matériau électriquement conducteur peut également recouvrir chaque portion de surface du substrat à partir de laquelle les éléments électroluminescents s'étendent, ou toute une surface ou face du substrat à partir de laquelle les ensembles d'éléments électroluminescents s'étendent.. La couche de matériau électriquement conducteur peut être isolée électriquement du matériau semi-conducteur du substrat par tout moyen. Cela permet d'alimenter les éléments électroluminescents 22 en électricité par le substrat. Ainsi, on peut alimenter les éléments électroluminescents en électricité simplement, c'est-à-dire en alimentant le matériau conducteur du substrat avec une polarité et la couche de matériau électriquement conducteur avec l'autre polarité.

La source lumineuse peut ainsi former un composant électroluminescent, en l'occurrence configuré en termes de spécifications et de performances pour un véhicule terrestre. Ce composant diffère des LEDs classiques qui émettent de la lumière à partir d'une ou plusieurs surfaces sensiblement planes ou au moins convexes ou régulières (par exemple moins de dix telles surfaces, e. g. de l'ordre de cinq). La source lumineuse permet notamment de réduire l'encombrement. La source lumineuse peut par ailleurs former intégralement un composant de taille individuelle plus grande qu'une LED classique, par exemple en termes de diamètre, c'est-à-dire la longueur du plus grand segment traversant le composant. Cela simplifie la réalisation du module lumineux car moins de composants sont nécessaires pour une fonction photométrique souhaitée. La source lumineuse permet également une luminance relativement élevée.

Le module lumineux peut comprendre plusieurs telles sources lumineuses , ou plusieurs modules lumineux comprenant une telle source lumineuse peuvent être intégrés au dispositif lumineux.

La source lumineuse peut être fabriquée par un procédé comprenant au moins une étape de fourniture du substrat, puis une étape de formation intégrale des bâtonnets avec le substrat, par croissance à partir du substrat. La couche de matériau électriquement conducteur peut être réalisée par une étape de dépose d'une finition métal, par exemple de cuivre pour assurer le pilotage des bâtonnets. Cette étape peut également comprendre la création de pads en aluminium ou cuivre sur une face du substrat, aptes à du câblage par fil entre la source et le composant de pilotage. Le câblage par fil ou « pontage » (également appelé « wirebonding » ou « wire bonding » de l'anglais ou encore ribbon bonding...) est une des techniques utilisées pour effectuer les connexions électriques entre la source lumineuse et le dispositif d'alimentation de la source. Le câblage est simplement réalisé par un fil (ou pont) soudé entre les deux plots de connexion prévus à cet usage sur chacun des éléments. La soudure peut être réalisée par ultrasons. Le matériau du fil peut être de l'aluminium, de l'or ou du cuivre. Le diamètre du fil peut être de l'ordre de 20 µm. Un fil de section rectangulaire peut aussi être utilisé.

La source lumineuse permet également une réalisation du module lumineux simple par ailleurs. En effet, les limitations d'efficacité en termes d'émission de lumière des LEDs classiques sont habituellement compensées soit par une augmentation de la puissance en entrée, soit par une multiplication du nombre de LEDs et/ou de modules optiques intégrant une LED. Ces deux dernières compensations augmentent d'autant plus l'encombrement du module lumineux. En outre, les compensations susmentionnées présentent l'inconvénient dans les modules intégrant une LED classique d'augmenter la chaleur générée, ce qui peut entraîner encore une augmentation de l'encombrement dû aux systèmes de refroidissement additionnels à mettre en place.

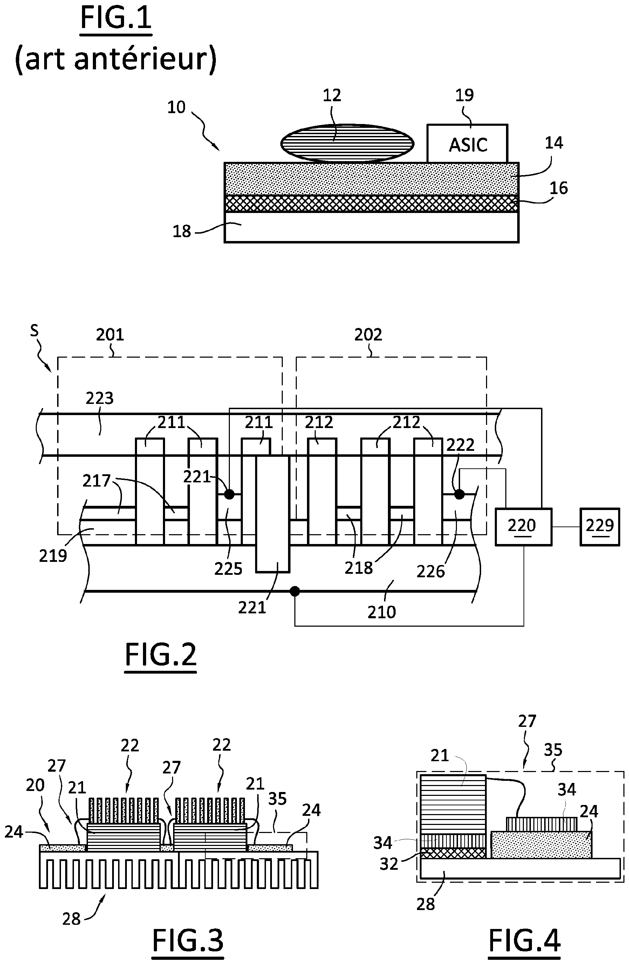

La FIG. 2 présente un exemple d'une telle source lumineuse.

La source lumineuse S, ici représentée en coupe, comprend un substrat 210 à partir duquel s'étendent selon une direction privilégiée des bâtonnets 211, 212.

Ce substrat 210 est, notamment dans cet exemple, du silicium, ce qui représente un coût bien moindre à celui des LEDs classiques, dans lesquelles les substrats sont en saphir. Les bâtonnets 211, 212, peuvent être obtenus par croissance cristalline sur ce substrat 210.

Les bâtonnets 211, 212, sont agencés de manière à former des bâtonnets en un matériau semi-conducteur électroluminescent. Les bâtonnets 211, 212, peuvent par exemple être formés essentiellement de nitrure de gallium.

Par exemple, ces bâtonnets 211, 212, comprennent une âme en matériau semi-conducteur apte à être dopé en électrons, autour de laquelle est formée une première couche en matériau semi-conducteur apte à présenter des déficits en électrons, dans ce cas on parle parfois de couche dopé en « trous » ou en charges positives. A l'interface de cette âme et de cette première couche, se forme une couche intermédiaire où se recombinent les électrons et les déficits en électrons. Ainsi, chaque bâtonnet 211, 212, est un élément semi-conducteur électroluminescent.

Une couche de nucléation 219 est formée sur le substrat 210 et autour des bâtonnets 211, 212.

Les bâtonnets 211, 212, sont ici distants d'environ 30 µm et ont chacun une hauteur, prise depuis la couche de nucléation 219 jusqu'à leur sommet, de 2,5 µm. Leur diamètre est de 1,5 µm.

La source lumineuse S comprend donc essentiellement un substrat 210 formant une plaque hérissée d'une multitude de petits bâtonnets 211, 212, électroluminescents et submillimétriques, à savoir dont la plus grande dimension est inférieure au millimètre.

La source lumineuse S est divisée en plusieurs zones lumineuses 201, 202 séparées par des murets 221, correspondant à une répartition de l'ensemble des bâtonnets 211, 212.

Entre chaque bâtonnets 211, 212 d'une même zone 201, 202est déposée une couche électriquement conductrice, joignant électriquement ces bâtonnets, formant ainsi une anode distincte 225, 226, pour chacune des zones lumineuses 201, 202.

Les quatre anodes 225, 226, ainsi formées sont en contact avec la couche de nucléation 219, qui elle-même est en contact avec la cathode formée par le substrat 210.

Ainsi, en connectant les anodes 225, 226 et la cathode 210 à une source d'alimentation, on peut alimenter en électricité indépendamment chacune des différentes zones lumineuses 201, 202.

Selon une réalisation, chaque anode est connectée à une ou plusieurs bornes positives d'un moyen de connexion 220, destiné à être connectée à la borne positive d'une source d'alimentation électrique (non représentée) d'un véhicule. De même, la cathode 210 est connectée à la borne négative du moyen de connexion 220. Le moyen d'activation permet donc l'alimentation électrique de chacune de ces zones lumineuses 201, 202.

Il est donc possible de piloter cette source lumineuse S, par activation sélective de ses zones lumineuses 201, 202, via le moyen d'activation 220.

Le pilotage peut être réalisé par un moyen spécifique distinct du dispositif lumineux, ou bien, comme dans cet exemple réalisé par un dispositif de pilotage 229 intégré au dispositif lumineux.

Dans cet exemple, le pilotage est réalisé directement par un dispositif de pilotage 229. Ce dernier est relié d'une part au moyen de connexion 220 et d'autre part au connecteur C. le moyen de connexion 220 est lui relié à chaque anode 225, 226, via des conducteurs électriques.

Le dispositif de pilotage 229 et la source lumineuse S sont montés sur une même carte de circuit imprimé, non représentée. Les conducteurs électriques sont formés par des pistes électroniques de cette carte de circuit imprimé. De même, d'autres pistes électroniques relient le moyen de connexion 220 au dispositif de pilotage 229.

Le rendement lumineux des zones lumineuses 201, 202 peut être amélioré en déposant une couche réfléchissante 217, 218, sur la couche de nucléation 219. Cette couche réfléchissante 217, 218, est par exemple déposée sur la couche de nucléation 219 avant croissance des bâtonnets, puis des trous sont ménagés dans cette couche réfléchissante 217, 218, ainsi que dans la couche de nucléation, avant croissance des bâtonnets 211, 212, sur le substrat 10.

Pour avoir un meilleur rendement lumineux, les bâtonnets des zones lumineuses peuvent avoir les caractéristiques ci-dessous :
- un diamètre compris entre 1,4 µm et 1,6 µm, par exemple 1 µm,
- une hauteur comprise entre 2 µm et 10 µm, par exemple 8 µm,
- une distance entre chaque bâtonnet comprise entre 3 et 10 µm.
la source lumineuse S peut comprendre un convertisseur de lumière 223 agencé au-dessus des bâtonnets 211, 212. Un convertisseur de lumière comprend au moins un matériau luminescent conçu pour absorber au moins une partie d'au moins une lumière d'excitation émise par une source lumineuse et pour convertir au moins une partie de ladite lumière d'excitation absorbée en une lumière d'émission ayant une longueur d'onde différente de celle de la lumière d'excitation. Le matériau peut par exemple être du YAG dopé au Cérium ou à l'Europium.

Le module lumineux comprend en outre au moins un dissipateur thermique associé au substrat de la source lumineuse. Le dissipateur thermique permet le transfert de la chaleur du ou des substrats de la source lumineuse lors de l'utilisation d'un module lumineux, notamment dans le contexte d'un véhicule terrestre. La source lumineuse et la coopération entre le dissipateur thermique et le substrat de ladite source de lumière permettent donc d'obtenir un module lumineux de véhicule terrestre simple à réaliser et à monter dans un dispositif lumineux de véhicule, induisant un encombrement relativement faible, compact et présentant une bonne capacité à dissiper de la chaleur.

Le dissipateur thermique permet une dissipation de chaleur via une coopération avec le substrat, c'est-à-dire que le dissipateur thermique reçoit la chaleur produite par le module lumineux et emmagasinée dans le substrat. Le dissipateur thermique est ainsi en communication de chaleur avec le substrat. Dans un exemple, le dissipateur thermique est agencé contre la deuxième face du substrat, directement ou indirectement. Cela signifie que la deuxième face transmet la chaleur présente dans le substrat au dissipateur thermique. Le dissipateur thermique peut alors dissiper cette chaleur au moins en partie hors du module lumineux.

Par exemple, le substrat peut présenter une forme générale de plaque, présentant deux faces opposées. Les bâtonnets électroluminescents peuvent alors s'étendre, par exemple tous, à partir d'une des deux faces. Le dissipateur thermique peut alors être agencé contre l'autre face de la plaque. Cela permet d'optimiser le nombre d'interfaces thermiques, l'espace et l'encombrement de la dissipation de chaleur, en conservant un module lumineux compact.

Pour une dissipation de chaleur optimisée, le dissipateur thermique peut comprendre pour chaque ensemble de bâtonnets une zone dissipant la chaleur en regard de l'ensemble, de l'autre côté de la plaque. Le dissipateur thermique peut comprendre une telle zone commune à tous les ensembles, ou une zone par ensemble de bâtonnets. Chaque zone peut dans un exemple présenter contre la plaque formée par le substrat une face sensiblement identique ou supérieure à la portion de surface de substrat portant l'ensemble de bâtonnets.

La transmission peut être assurée par le fait que le dissipateur thermique est dans un exemple agencé directement contre le substrat. Cela signifie que le dissipateur thermique est en contact physique (i. e. de matériau) avec le substrat.

Le dissipateur thermique peut toutefois être alternativement agencé contre le substrat via un élément intermédiaire. L'élément intermédiaire est agencé entre le substrat et le dissipateur thermique. L'élément intermédiaire peut présenter deux faces opposées, l'une agencée directement contre le substrat, l'autre directement contre le dissipateur. L'élément intermédiaire peut comprendre un espace vide de matériau (i.e. formé intégralement d'une barrière d'air), ou alternativement inclure un ou plusieurs matériaux (e. g. sans aucune couche formant barrière d'air) ou être constitué d'un ou plusieurs matériaux (i. e. sensiblement pas d'air). Pour améliorer le transfert thermique, l'élément intermédiaire peut comprendre par exemple de la graisse thermique ou un matériau à changement de phase. L'élément intermédiaire peut ne pas contenir de PCB (carte de circuit imprimé, de l'anglais « printed circuit board »). Cela est rendu possible grâce à la source lumineuse spécifique utilisée. L'élément intermédiaire peut ne pas contenir de couche de matériau constitutif du substrat d'un PCB faisant barrière au passage de la chaleur depuis le substrat vers le dissipateur thermique. Par exemple, l'élément intermédiaire peut être dépourvu de couche de résine e. g. époxy et/ou polymère,. Cela permet une meilleure dissipation thermique, en réduisant le nombre d'interfaces thermiques comparativement à l'utilisation de PCB.

Dans tous les cas, le coefficient thermique de la transmission de chaleur depuis le substrat vers le dissipateur thermique peut être supérieur à égal à 1w/m/K. Ainsi, le module lumineux dissipe efficacement la chaleur.

Dans le cas d'un élément intermédiaire entre le substrat et le dissipateur thermique, l'élément intermédiaire peut comprendre un pont thermique de matériau entre le substrat et le dissipateur thermique. En d'autres termes, l'élément intermédiaire est constitué de telle sorte que la chaleur du substrat est transmise au dissipateur par une conduction qui suit un chemin le long duquel du matériau est continuellement disposé. Le chemin est dépourvu de toute barrière d'air. Un tel pont thermique permet une meilleure conduction qu'en cas de présence d'une barrière d'air isolante.

Le pont thermique peut être constitué d'un ensemble d'un ou plusieurs matériaux consécutifs depuis le substrat jusqu'au dissipateur thermique, c'est-à-dire l'ensemble des matériaux transmettant successivement la chaleur depuis le substrat vers le dissipateur thermique. Les matériaux de l'ensemble peuvent dans un exemple présenter chacun une conductivité thermique supérieure ou égale à 1w/m/K, à 10w/m/K, à 50w/m/K ou encore à-100w/m/K. L'épaisseur totale de l'élément intermédiaire peut être entre 1µm et 500µm. L'ensemble de ces matériaux peut être dépourvu de résine e. g. époxy et/ou polymère, et/ou de céramique. Le pont thermique peut comprendre parmi ses matériaux constitutifs une ou plusieurs pâtes thermiques. Un tel matériau améliore la conduction de chaleur depuis le substrat jusqu'au dissipateur thermique, en assurant un bon contact entre les deux composants, tout en étant isolant électriquement. En outre, la pâte thermique peut être adhésive. La pâte thermique peut comprendre de la colle (par exemple de la colle époxy) et/ou de la glue adhésive. Cela permet une fixation par adhésion ou collage, en plus d'améliorer la conduction thermique. Alternativement ou de manière additionnelle, toute fixation peut être réalisée par soudure, le pont thermique comprenant alors un matériau de soudure, par exemple un métal. Alternativement ou de manière additionnelle, le pont thermique peut comprendre un ou plusieurs métaux conducteurs électriques, par exemple du cuivre. Cela permet une bonne répartition de la chaleur, mais également une conduction électrique.

Le module lumineux peut comprendre un ou plusieurs dispositifs électroniques apte(s) à commander les éléments électroluminescents. Un tel dispositif électronique peut être par exemple un circuit intégré ou un convertisseur de puissance.

Un convertisseur de puissance est un dispositif de conversion d'une alimentation électrique issue d'un réseau d'alimentation électrique du véhicule en une alimentation électrique adaptée à la réalisation d'une fonction lumineuse souhaitée, et éventuellement à fournir ladite alimentation électrique adaptée à une source lumineuse pour la réalisation de ladite fonction lumineuse souhaitée.

Un circuit intégré, encore appelé puce électronique, est un composant électronique reproduisant une ou plusieurs fonctions électroniques et pouvant intégrer plusieurs types de composants électroniques de base, par exemple dans un volume réduit (i.e. sur une petite plaque). Cela rend le circuit facile à mettre en œuvre.

Le circuit intégré peut être par exemple un ASIC ou un ASSP.

Un ASIC (acronyme de l'anglais « Application-Specific Integrated Circuit ») est un circuit intégré développé pour au moins une application spécifique (c'est-à-dire pour un client). Un ASIC est donc un circuit intégré (micro-électronique) spécialisé. En général, il regroupe un grand nombre de fonctionnalités uniques ou sur mesure.

Un ASSP (acronyme de l'anglais « Application Specific Standard Product ») est un circuit électronique intégré (micro-électronique) regroupant un grand nombre de fonctionnalités pour satisfaire à une application généralement standardisée. Un ASIC est conçu pour un besoin plus particulier (spécifique) qu'un ASSP

Dans le cas où le pont thermique comprend un ou plusieurs métaux conducteurs électriques, la conduction électrique permet d'intégrer de tels dispositifs électroniques à l'élément intermédiaire, qui peuvent alors être alimentés via le métal conducteur électrique.

Le substrat peut être alimenté en électricité par un circuit imprimé directement ou via le dispositif électronique, lui-même alimenté en électricité par le circuit imprimé, le dispositif électronique alimentant alors le substrat en électricité, par exemple directement. Par exemple, le substrat peut être alimenté en électricité par le circuit imprimé via un dispositif électronique apte à commander les éléments électroluminescents. Le module peut comprendre un câblage par fil entre le circuit imprimé et le dispositif électronique et une soudure entre le dispositif électronique de commande et le substrat.

L'élément intermédiaire comprend un ou plusieurs tels dispositifs électroniques de commande. Cette électronique peut être configurée pour interagir avec des composants du module lumineux. Notamment, chaque dispositif électronique de commande peut être configuré pour commander un ou plusieurs ensembles de bâtonnets du module lumineux. Ainsi, l'électronique de commande du module lumineux est au plus près du dissipateur thermique. Cette électronique générant également de la chaleur, cette solution permet d'optimiser la dissipation de chaleur. En outre, cette solution permet d'améliorer la compacité du module lumineux, en évitant tout d'abord un dispositif électronique de commande séparé du module lumineux et donc la prévision de place supplémentaire et l'ajout de connecteur nécessaire.

Par exemple, chaque dispositif électronique de commande peut être configuré pour commander un ensemble de bâtonnets respectif. L'élément intermédiaire portant le dispositif électronique de commande peut alors être en regard de cet ensemble de bâtonnets. Cela permet d'optimiser la dissipation thermique et la compacité du module lumineux, tout en ayant l'électronique de commande au plus près des composants commandés.

Dans ce cas ou dans d'autres cas, l'élément intermédiaire peut être constitué d'un empilement de couches englobant tout autour ou maintenant de part et d'autre un dispositif électronique de commande. Les couches peuvent, par exemple chacune, être dans l'un des matériaux indiqués ci-dessus et ainsi assurer une bonne conduction de chaleur.

Alternativement ou de manière additionnelle, le module lumineux peut comprendre un ou plusieurs dispositifs électroniques de commande tels que mentionnés ci-dessus, portés par le substrat. De tels dispositifs électroniques de commande peuvent par exemple être soudés sur le substrat et être alimentés en électricité par le substrat, par des processus standards. Cela permet également d'améliorer la compacité du module lumineux. En effet, dans l'art antérieur, un driver fixé sur le composant d'un module LED induit un auto-échauffement de la LED par le driver, ce qui peut réduire la performance en flux. De même, le driver se trouve auto échauffé par la LED, donc plus sensible thermiquement. Dans l'art antérieur, cela peut conduire à un dimensionnement plus important du dissipateur thermique pour un objectif de refroidissement donné.

Les avantages du module lumineux en termes de dissipation de la chaleur d'exemples sont maintenant illustrés en référence à la FIG. 1 qui montre une solution de l'art antérieur.

La FIG. 1 montre schématiquement un module lumineux selon l'art antérieur. La FIG. 1 représente un module lumineux 10 pour véhicule automobile comprenant une source lumineuse 12, par exemple une LED, un PCB 14, une interface thermique 16 comprenant de la graisse, et un dissipateur thermique 18. Le dispositif 19 commande la source lumineuse 12 et assure la fonction d'éclairage et/ou de signalisation du module 10. Comme on peut le voir sur la figure, le dissipateur thermique 18 coopère avec le PCB 14. Le PCB 14 présente une résistance thermique qui entrave ainsi la conduction de chaleur depuis la LED 12 jusqu'au dissipateur thermique 18. Cela réduit l'efficacité du refroidissement dans le cas de système nécessitant une large surface d'émission et dissipation plus large que les LEDs unitaires à une ou plusieurs puce(s) ou « chip » en anglais, et ou nécessitant des performances supérieures et donc une température de fonctionnement de la source plus basse que les modules conventionnels .

La source lumineuse permet au contraire de s'affranchir du PCB et d'avoir un agencement du dissipateur contre le substrat. Le substrat fait ainsi fonction de support de fixation au dissipateur thermique, potentiellement par le biais de l'élément intermédiaire.

Différents exemples de caractéristiques de la source lumineuse sont maintenant discutés. Ces exemples permettent notamment de simplifier la fonction de support du dissipateur thermique et/ou d'améliorer la luminescence et/ou la dissipation de chaleur.

La source lumineuse peut présenter une structure permettant de générer des sources d'émission de taille individuelle strictement supérieure à 50µm*50µm, par exemple supérieure à 75µm*75µm, ou encore supérieure ou de l'ordre de 100µm*100µm. Le substrat peut par exemple présenter une forme de plaque dont la largeur et la longueur présentent des valeurs correspondantes. Ces dimensions permettent au substrat de porter un dissipateur thermique efficace, même dans le cas d'un unique ensemble de bâtonnets. La taille de la source d'émission et leur rapprochement permettent de mieux répartir la chaleur par rapport à des sources LEDs classiques (par exemple de type « multi-chip ») dont la taille est généralement inférieure à 50µm*50µm. La dimension et les caractéristiques conductrices du substrat peuvent être utilisées pour coller ou souder la LED sur un dissipateur thermique, éventuellement via un élément intermédiaire. Cela permet d'éliminer le PCB. La technologie pour connecter les sources à l'alimentation peut consister à intégrer au substrat la couche conductrice.

Les dimensions de chaque bâtonnet sont submillimétriques. Cela signifie que sensiblement chaque dimension de chaque bâtonnet est inférieure au millimètre. Les bâtonnets peuvent par exemple présenter une hauteur supérieure à 1µm, à 3µm, ou à 5µm, et/ou inférieure à 50µm, à 25µm, ou à 15µm, par exemple de l'ordre de 8µm. Les bâtonnets peuvent présenter un diamètre de section (i. e. plus grande longueur de la section) constant ou variable. Le plus grand diamètre ou le diamètre (constant) peut être inférieur à 15µm, 10µm, ou 3µm, et/ou le plus petit diamètre ou le diamètre (constant) peut être supérieur à 0.05µm, 0.1µm, ou 0.5µm, par exemple de l'ordre de 1µm. Les bâtonnets peuvent présenter une section de forme quelconque, par exemple de forme générale circulaire ou polygonale, par exemple pentagonale ou hexagonale. Le pas ou distance d'un bâtonnet à celui ou ceux les plus proches (i.e. la distance entre deux bâtonnets immédiatement adjacents) peut être non nul, c'est-à-dire qu'il existe un espacement entre les bâtonnets. Cet espacement peut être variable. Il peut varier dans un intervalle dont la borne inférieure est supérieure à 0.5µm, ou à 1µm, et/ou inférieure à 5µm ou à 4µm, par exemple sensiblement égale ou de l'ordre de 3µm, et/ou dont la borne supérieure est inférieure à 50µm, à 25µm, ou à 15µm, et/ou supérieure à 5µm ou à 7µm, par exemple sensiblement égale ou de l'ordre de 10µm.

Le matériau semi-conducteur du substrat peut comprendre du silicium et/ou du carbure de silicium. Le matériau semi-conducteur (respectivement le substrat) peut être majoritairement en silicium, c'est-à-dire que la teneur en silicium dans le matériau semi-conducteur (respectivement le substrat) est supérieure à 50%. Le silicium est particulièrement économique et conduit bien la chaleur.

La luminance des bâtonnets électroluminescents peut être supérieure à 40Cd/mm², 50Cd/mm², ou 60Cd/mm². Chaque bâtonnet peut émettre des rayons lumineux le long de sa hauteur (c'est-à-dire le long d'une direction perpendiculaire à un plan majoritaire d'extension du substrat) et en bout de celui-ci. Le substrat peut présenter une première face par laquelle la lumière est émise, et une deuxième face coopérant avec le dissipateur thermique. Les bâtonnets peuvent être portés par la première face. La première face et la deuxième face peuvent être sensiblement parallèles entre elles. Le dissipateur thermique peut recouvrir seulement partiellement la source lumineuse, ou bien totalement.

Deux exemples schématiques du module lumineux sont maintenant présentés en référence aux FIGs. 3-6, les figures n'étant pas à l'échelle.

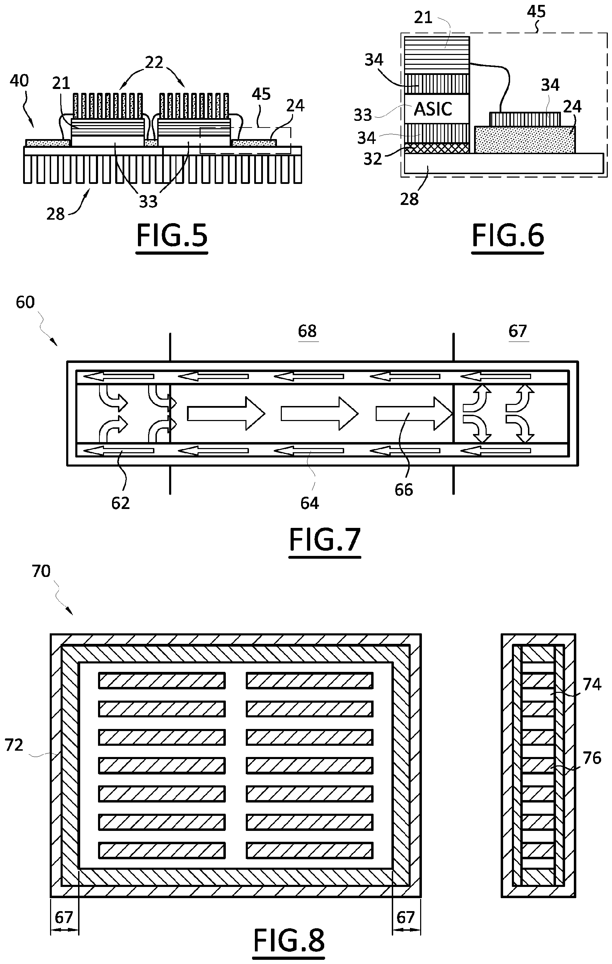

Le module 20 selon l'exemple des FIGs. 3-4 et le module 40 selon l'exemple des FIGs. 5-6 comprennent chacun deux sources lumineuses. Chaque source lumineuse comprend un substrat 21 et un unique ensemble de bâtonnets 22 s'étendant à partir du substrat 21. Dans les deux exemples, le module (20, 40) comprend un dissipateur thermique 28, agencé contre les substrats et recouvrant les deux sources lumineuses 21-22. Chaque substrat 21 présente une forme de plaque. Les bâtonnets 22 s'étendent à partir d'une première face (vers le haut sur les figures). Et le dissipateur 28 est agencé contre la deuxième face. Dans les exemples, le dissipateur 28 est représenté sous la forme d'un unique radiateur à ailettes, formé intégralement et coopérant avec les deux substrats 21. Le dissipateur 28 est ainsi formé de deux sous-dissipateurs venus de matière ensemble et coopérant chacun avec un substrat 21 distinct. Mais le module peut alternativement comprendre plusieurs radiateurs à ailettes (par exemple un par substrat 21 et/ou par ensemble de bâtonnets 22) et/ou d'autres types de dissipateurs.

Dans les deux exemples, le dissipateur thermique 28 est agencé contre chaque substrat 21 via un élément intermédiaire (32-34). L'élément intermédiaire du module 20 de l'exemple de la FIG. 3 est montré par l'agrandissement de la zone 35 du module 20 représenté par la FIG. 4. De même, l'élément intermédiaire du module 40 de l'exemple de la FIG. 5 est montré par l'agrandissement de la zone 45 du module 40 représenté par la FIG. 6.

L'élément intermédiaire du module 20 comprend successivement, depuis le dissipateur 28 vers le substrat 21, une couche de pâte thermique adhésive 32 et une couche de cuivre 34. La couche de cuivre 34 de la zone 35 du module 20 permet d'avoir une sortie en courant électrique du substrat 21.

L'élément intermédiaire du module 40 comprend successivement, depuis le dissipateur 28 vers le substrat 21, une couche de pâte thermique adhésive 32, une couche de cuivre 34, un ASIC 33, et une autre couche de cuivre 34. Les couches de cuivre 34 permettent l'alimentation en électricité de l'ASIC 33. Chaque ASIC 33 peut être configuré pour commander une source lumineuse 21-22 respective. Chaque ASIC 33 peut être agencé en regard de la source lumineuse ainsi commandée. La commande est donc particulièrement efficace. La solution est compacte. Les ASICs 33 bénéficient de la dissipation de chaleur réalisée par le dissipateur 28.Dans les deux exemples, le substrat 21 est alimenté en électricité par un circuit imprimé 24 (PCB). A la différence de l'art antérieur représenté en FIG. 1, le PCB 24 ne fait pas partie de l'élément intermédiaire avec le dissipateur thermique 28. En effet, le PCB 24 contourne le substrat 21, ce qui signifie que le PCB 24 ne passe pas en regard de la deuxième face du substrat 21. Cela est rendu possible et peut être réalisé facilement grâce à la configuration des sources lumineuses 21-22, et notamment par l'accès par l'extérieur à la conduction électrique réalisée par le substrat 21.

Par exemple, le PCB 24 est fait de plusieurs pièces assemblées en laissant un espace (e. g. trou ou orifice) entre elles, ou d'une seule pièce présentant un trou, et le substrat 21 coopère avec le dissipateur thermique 28 à travers l'espace ou le trou. Le PCB 24 délimite ainsi la zone où l'élément intermédiaire 32-34 peut opérer contre le dissipateur 28. L'élément intermédiaire 32-34 est agencé au moins partiellement dans cet espace ou trou. Le substrat 21 est agencé au niveau de ce trou, au-dessus du trou dans les exemples montrés sur les figures. Les éléments semi-conducteurs électroluminescents s'étendent d'un côté du PCB 24 (vers le haut sur les figures), le dissipateur thermique 28 étant agencé contre la deuxième face du substrat 21 de l'autre côté du PCB 24 (vers le bas sur les figures).

Dans l'exemple des figures le PCB 24 est fixé au dissipateur thermique 28, comme on le voit sur les FIGs. 4 et 6. Le PCB 24 et l'ensemble constitué par chaque source lumineuse 21-22 et son élément intermédiaire 32-34 de coopération sont donc contre le radiateur 28, et le PCB 24 contourne ledit ensemble. Dans l'exemple des figures, le substrat 21 est alimenté en électricité par le PCB 24 via un câblage par fil 27. Le substrat 21 alimente à son tour les bâtonnets 22. Alternativement, le substrat 21 pourrait être alimenté en électricité par le PCB 24 via une soudure entre le substrat et une couche conductrice du PCB. L'amenée de courant électrique peut par exemple être faite par la face avant du substrat 21 (côté bâtonnets 22). Dans ce cas, les sources lumineuses peuvent être montées en série ou parallèles et alimentées via le wirebonding.

Un dispositif lumineux peut comprendre une ou plusieurs sources lumineuses sur le même substrat selon l'une quelconque des différentes réalisations exposées jusqu'ici. Le dispositif partage un même dissipateur thermique, comme discuté en référence aux FIGs. 3-6. En cas de pluralité de source émettrice sur le même substrat, les sources peuvent être décalées les unes par rapport aux autres. Un des avantages est de pouvoir réaliser le pilotage par source individuellement.

Le dispositif lumineux peut être configuré pour l'éclairage et/ou la signalisation d'un véhicule terrestre, par exemple un véhicule automobile. Le dispositif lumineux peut être configuré pour réaliser une fonction photométrique. Une fonction photométrique est par exemple une fonction d'éclairage et/ou de signalisation visible pour un œil humain. Dans le domaine de l'automobile, cette fonction photométrique peut se conformer à la réglementation en vigueur dans le pays où elle est utilisée, elle peut alors être qualifiée de réglementaire. Les fonctions photométriques réglementaires comprennent par exemple à la date de dépôt de la présente demande : - le feu diurne (DRL), réglementation 087 UNECE, - le feu de position, réglementation 007 UNECE, - le feu de code, réglementations 87 UNECE, - le feu de route, réglementation - le feu de recul, réglementation 023 UNECE, - le feu stop, réglementation 007 UNECE, - l'indicateur de direction, réglementation 006 UNECE, - le feu antibrouillard, réglementations 019 et 038 UNECE, La réglementation peut contenir des exigences de colorimétrie, d'intensité, de répartition spatiale selon une grille dite photométrique ou encore de plages de visibilité de la lumière émise.

Comme indiqué en référence aux exemples, le dissipateur thermique peut de manière générale comprendre un ou plusieurs radiateurs à ailettes. Le dissipateur thermique peut par exemple comprendre une plaque présentant un premier côté et un deuxième côté. Le premier côté coopère avec le substrat et le deuxième côté présente des ailettes de refroidissement. Les ailettes de refroidissement font saillie depuis le deuxième côté. Le dissipateur thermique peut être réalisé en un matériau qui présente une conductivité thermique supérieure ou égale à 5W/(m.K), supérieure ou égale à 50W/(m.K), ou encore supérieure ou égale à 100W/(m.K) pour des fonctions d'éclairages. Le dissipateur peut par exemple être métallique ou en plastique conducteur, ou être en un matériau composite. Le dissipateur thermique peut par exemple comporter du magnésium et/ou de l'aluminium et/ou du cuivre et/ou un polymère thermo-conducteur. Ces caractéristiques participent à une réalisation simple mais assurant un bon refroidissement. Ces dissipateurs peuvent être refroidis en convection naturelle ou forcée selon le besoin.

Pour améliorer la dissipation de chaleur, le substrat du module lumineux peut intégrer un système de répartition de chaleur intégré au substrat. Le système de répartition de chaleur répartit la chaleur de manière sensiblement homogène dans la partie du substrat coopérant avec le dissipateur thermique. Ainsi, les capacités du dissipateur thermique sont pleinement utilisées, et la dissipation de chaleur est optimisée. Le système de répartition de chaleur peut présenter une surface égale ou supérieure à celle des zones portant les éléments électroluminescents. Le système de répartition de chaleur peut par exemple comprendre des micro-caloducs. Cela permet une dissipation particulièrement efficace, en particulier dans la configuration où l'élément intermédiaire comprend un ou plusieurs dispositifs électroniques de commande.

Le système de répartition de chaleur peut être configuré pour bien répartir la chaleur vers le radiateur pour maximiser son efficacité en intégrant un ou plusieurs micro-caloducs dans la structure du substrat, par exemple silicium. Les micro-caloducs peuvent être formés de réseaux capillaires qui permettent de drainer le liquide depuis la zone chaude de la source et de l'ASIC vers la zone froide. Un micro caloduc peut être gravé grâce aux procédés standards de réalisation des puces. Ce moyen de refroidissement intégré à la source lumineuse et à l'intelligence permet de mieux maîtriser la thermique en étalant le point chaud vers le dissipateur thermique.

Un micro-caloduc est constitué de réseaux de quelques millimètres dans lequel un fluide s'évapore et se transporte en phase vapeur vers la zone froide. En raison de la faible longueur (par exemple inférieure à 20cm), l'effet par capillarité permet de fonctionner sans l'aide de la gravité. La FIG. 7 illustre le principe de fonctionnement d'un micro-caloduc 60. Le fluide est représenté par les flèches. Le fluide circule sous forme liquide 64 dans le réseau capillaire 62 du micro-caloduc 60, passe en phase vapeur 66 au niveau d'une zone formant évaporateur, traverse une zone adiabatique 68, puis repasse sous forme liquide dans une zone formant condenseur 67, et ainsi de suite.

L'intérieur du micro-caloduc peut comprendre des matériaux présentant une structure irrégulière réalisée par du frittage de poudre ou des rainures. Un micro-caloduc de forme plate peut être inséré dans une préforme définie directement dans le substrat, ou alternativement dans une matière conductrice pour permettre l'étalement de la chaleur. Le micro-caloduc peut comprendre des rainures parallèles remplies de fluide. La FIG. 8 illustre un micro-caloduc 70 selon un tel exemple. Un réseau capillaire est défini entre les parois 72 de micro-caloduc 70. La condensation se fait au niveau des zones 67 bordant les rainures frittées 76 et les espaces vapeur 74.

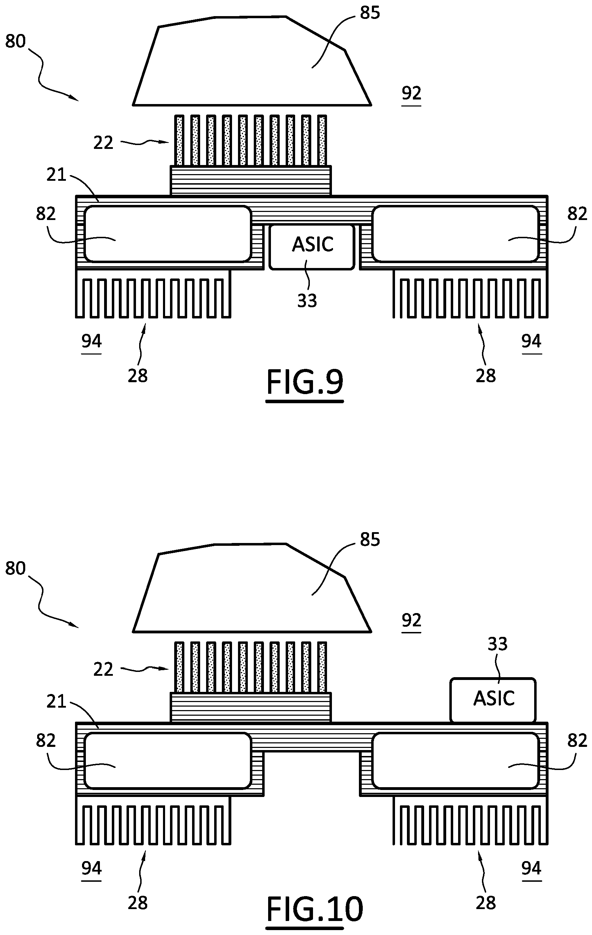

Les FIGs. 9-10 montrent d'autres exemple schématiques du module lumineux, intégrés à un dispositif lumineux et comprenant des micro-caloducs, les figures n'étant pas à l'échelle.

La FIG. 9 montre un exemple d'un dispositif lumineux intégrant un module lumineux 80 et une lentille 85. Le module lumineux 80 comprend le substrat 21 et les bâtonnets 22, ainsi que l'ASIC 33. Le dissipateur thermique 28 est en deux parties chacune agencée contre le substrat 21 sous le dispositif lumineux 80, en référence à l'orientation de la figure. Le dissipateur thermique pourrait être d'un seul tenant et recouvrir toute la face inférieure du module. Le substrat 21 intègre deux ensembles de micro-caloducs 82. Les micro-caloducs 82 permettent une bonne répartition de la chaleur dans le substrat, avant transmission au dissipateur thermique, en exploitant la zone chaude 92 et la zone froide 94 comme indiqué précédemment.

La FIG. 10 montre un dispositif lumineux qui diffère du dispositif lumineux de la FIG. 9 en ce que l'ASIC 33 du module lumineux 90 est agencé sur le substrat 21, en référence à l'orientation de la figure. Dans ce cas, contrairement aux réalisations des FIGs. 5-6 et 9, l'ASIC peut être électriquement connecté par exemple par un câblage par fils. L'ASIC pourrait également se situer au niveau de l'élément intermédiaire entre le dissipateur 28 et le substrat 21, donc sous un micro-caloduc 82 en référence aux figures, tel que décrit en référence aux FIGs. 5-6.

Le circuit imprimé (PCB) permettant d'alimenter le substrat peut être rigide. Le PCB peut dans un exemple alternatif être flexible (du type FPCB, de l'anglais « Flexible Printed Circuit Board »). Le module lumineux permet alors d'assurer l'alimentation flexible en électricité, tout en réduisant les limitations de dissipation thermique inhérentes. Dans un autre exemple, le module comprend à la place d'un PCB rigide ou d'un FPCB un dispositif d'interconnexion à géométrie variable, notamment du type MID (de l'anglais « Molded In Device »).

L'application de source LED sur PCB flexible peut être intéressante pour des formes de produits compliquées, ou de répartition lumineuse complexe comme des DRL faisant le tour d'un projecteur, des fonctions feux arrières, ou des fonctions de contours de pièces lumineuses pour éclairage intérieur. Un PCB flexible dissipe toutefois mal la chaleur, du fait notamment de la couche adhésif de la dernière couche de cuivre sur la plaque radiateur. Cette couche a la fonction de raidisseur mécanique.

Le dispositif lumineux dans sa configuration où le substrat est alimenté en électricité par un PCB qui contourne le substrat, tel que présenté par exemple en références aux FIGs. 3-6, permet une bonne dissipation de chaleur tout en conservant les avantages du PCB flexible. En effet, la flexibilité de la connexion entre différentes pièces est exploitée, mais le PCB flexible et la couche d'adhésif raidissant ne viennent pas entraver la dissipation de chaleur liée à la fonction d'éclairage.

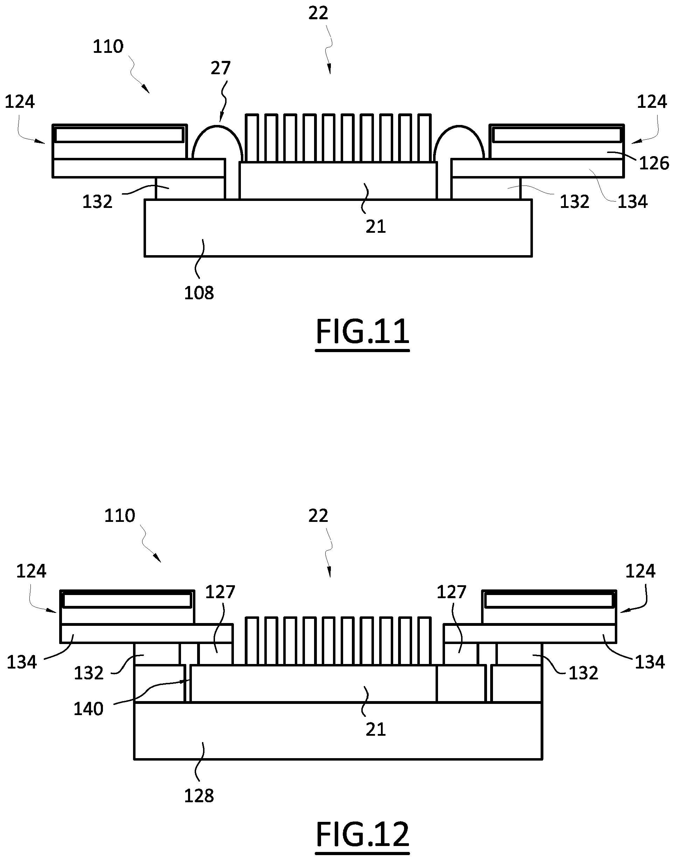

Les FIGs. 11-12 montrent d'autres exemples schématiques du module lumineux, intégrant un PCB flexible, les figures n'étant pas à l'échelle.

Le module lumineux 100 de la FIG. 11 et le module 110 de la FIG. 12 comprennent chacun une source lumineuse 21-22 et un dissipateur thermique 108,128 agencé contre le substrat 21. Par exemple, le dissipateur thermique 108,128 peut être agencé contre le substrat 21 tel que selon l'un quelconque des exemples décrits précédemment, par exemple via un élément intermédiaire tel que décrit plus haut, par exemple en référence aux FIGs. 3-6, l'élément intermédiaire n'étant pas représentée sur les FIGs. 11-12. La source lumineuse 21-22 peut par exemple être fixée sur le dissipateur thermique 108,128 par une fixation comprenant de la colle (e. g. conductrice de chaleur) ou de la soudure.

Les modules 100 et 110 comprennent chacun un circuit imprimé 124 flexible. Le PCB flexible 124 comprend une couche 126 de polyamide adhésif collée sur une couche 134 de cuivre. Tout autre type de PCB flexible convient. Le PCB flexible 124 est fixé au dissipateur thermique par une fixation 132, qui peut être par exemple de la colle ou une soudure. Le PCB flexible 124 réalise l'alimentation en électricité de chacune des sources lumineuses 21-22. Comme on le voit sur les figures, le PCB flexible 124 contourne la source lumineuse 21, 22 et conserve ainsi sa flexibilité. Cela est rendu possible par le fait que le dissipateur thermique 28 peut coopérer avec le substrat 21 pour le refroidir sans passer par le PCB. Ainsi, la fixation 132 entre le dissipateur thermique 28 et le PCB flexible 124 est adaptée selon les règles de l'art pour assurer l'absence de défaillance du FLEX en fiabilité par des liaisons mécaniques annexes comme par exemple du bouterollage ou vissage selon les besoins.

Dans l'exemple de la FIG. 11, le PCB flexible 124 alimente la source lumineuse 21, 22 via un câblage par fils 27, comme dans l'exemple des FIGs. 3-6. Dans l'exemple de la FIG. 12, le PCB flexible 124 alimente la source lumineuse 21-22 via une soudure 127 entre le substrat 21 et la couche conductrice en électricité du PCB, c'est-à-dire la couche de cuivre 134 dans l'exemple.

Par ailleurs, le module 110 de la FIG. 12 diffère des autres modules en ce que le dissipateur thermique 128 présente une cavité 140. La cavité 140 forme un logement pour le substrat 21, par exemple de forme complémentaire au substrat 21.

De manière générale, le dissipateur thermique peut comprendre une telle cavité formant logement, par exemple de forme complémentaire, pour tout composant du module, par exemple le substrat ou l'élément intermédiaire, notamment le dispositif électronique de commande.

Egalement, de manière générale le dissipateur thermique peut être surmoulé dans un plastique pour être débouchant à l'extérieur. Cela assure un refroidissement efficace, notamment pour des structures de faibles épaisseurs.

## Revendications

1. Module lumineux (20) de véhicule terrestre comprenant :
- au moins une source lumineuse à semi-conducteur comportant un substrat (21) majoritairement en matériau semi-conducteur, le substrat présentant une première face et une deuxième face, la source lumineuse comportant en outre des éléments électroluminescents (22) de dimensions submillimétriques s'étendant à partir de la première face du substrat ; et
- au moins un dissipateur thermique (28) coopérant avec la deuxième face du substrat de manière à évacuer la chaleur produite par la source lumineuse **caractérise en ce que** le substrat (21) est alimenté en électricité par un circuit imprimé (24), le circuit imprimé (24) contournant le substrat (21) le dissipateur thermique (28) est agencé contre la deuxième face du substrat (21) via un élément intermédiaire (32-34) qui comprend un ou plusieurs dispositifs électroniques de commande .

2. Module lumineux selon la revendication 1, dans lequel le matériau semi-conducteur comporte du silicium.

3. Module lumineux selon la revendication 1 ou 2, dans lequel les éléments électroluminescents sont répartis dans différentes zones d'émission lumineuse activables sélectivement.

4. Module lumineux (100, 110) selon l'une des revendications 1-3, dans lequel le circuit imprimé (124) est flexible.

5. Module lumineux selon l'une des revendications 1-4, dans lequel l'élément intermédiaire comprend une pâte thermique.

6. Module lumineux selon l'une des revendications 1-5, dans lequel l'élément intermédiaire comprend une couche de cuivre.

7. Module lumineux selon l'une des revendications 1-6, dans lequel la source lumineuse est collée ou soudée au dissipateur thermique.

8. Module lumineux selon l'une des revendications 1-7, **caractérisé en ce que** le au moins un dispositif électronique est apte à commander les éléments électroluminescents.

9. Module lumineux selon l'une des revendications 1-8, dans lequel le dispositif électronique comprend au moins un convertisseur de puissance et/ou un circuit intégré.

10. Module lumineux (80) selon l'une des revendications 1-9, dans lequel le dissipateur thermique (28) comprend un ou plusieurs radiateurs à ailettes.

11. Module lumineux (80) selon l'une des revendications 1-10, comprenant en outre un système de répartition de chaleur intégré au substrat.

12. Module lumineux selon la revendication 11, dans lequel le système de répartition de chaleur comprend un ou plusieurs micro-caloducs (82).

13. Dispositif lumineux (80-85, 90-95), notamment d'éclairage et/ou de signalisation de préférence de véhicule terrestre, comprenant un module lumineux selon l'une des revendications 1-12.

## Patentansprüche

1. Leuchtmodul (20) für ein Landfahrzeug, umfassend:
- mindestens eine Halbleiterlichtquelle, die ein überwiegend aus Halbleitermaterial bestehendes Substrat (21) beinhaltet, wobei das Substrat eine erste Seite und eine zweite Seite aufweist, wobei die Lichtquelle ferner elektrolumineszente Elemente (22) mit Submillimeterabmessungen beinhaltet, die sich von der ersten Seite des Substrats aus erstrecken; und
- mindestens einen Wärmeableiter (28), der mit der zweiten Seite des Substrats so zusammenwirkt, dass er die von der Lichtquelle erzeugte Wärme abführt, **dadurch gekennzeichnet, dass** das Substrat (21) von einer Leiterplatte (24) mit Strom versorgt wird, wobei die Leiterplatte (24) um das Substrat (21) herumgeführt ist, und der Wärmeableiter (28) gegen die zweite Seite des Substrats (21) über ein Zwischenelement (32-34) angeordnet ist, das eine oder mehrere elektronische Steuervorrichtungen umfasst.

2. Leuchtmodul nach Anspruch 1, bei dem das Halbleitermaterial Silicium beinhaltet.

3. Leuchtmodul nach Anspruch 1 oder 2, bei dem die elektrolumineszenten Elemente auf verschiedene, selektiv aktivierbare Lichtemissionsbereiche verteilt sind.

4. Leuchtmodul (100, 110) nach einem der Ansprüche 1-3, bei dem die Leiterplatte (124) flexibel ist.

5. Leuchtmodul nach einem der Ansprüche 1-4, bei dem das Zwischenelement eine Wärmeleitpaste umfasst.

6. Leuchtmodul nach einem der Ansprüche 1-5, bei dem das Zwischenelement eine Kupferschicht umfasst.

7. Leuchtmodul nach einem der Ansprüche 1-6, bei dem die Lichtquelle an den Wärmeableiter geklebt oder geschweißt ist.

8. Leuchtmodul nach einem der Ansprüche 1-7, **dadurch gekennzeichnet, dass** die mindestens eine elektronische Vorrichtung geeignet ist, die elektrolumineszenten Elemente zu steuern.

9. Leuchtmodul nach einem der Ansprüche 1-8, bei dem die elektronische Vorrichtung mindestens einen Leistungswandler und/oder eine integrierte Schaltung umfasst.

10. Leuchtmodul (80) nach einem der Ansprüche 1-9, bei dem der Wärmeableiter (28) einen oder mehrere Rippenkühlkörper umfasst.

11. Leuchtmodul (80) nach einem der Ansprüche 1-10, das ferner ein in das Substrat integriertes Wärmeverteilungssystem umfasst.

12. Leuchtmodul nach Anspruch 11, bei dem das Wärmeverteilungssystem ein oder mehrere Mikro-Wärmeleitrohre (82) umfasst.

13. Leuchtvorrichtung (80-85, 90-95), insbesondere zur Beleuchtung und/oder Signalisierung, bevorzugt für ein Landfahrzeug, die ein Leuchtmodul nach einem der Ansprüche 1-12 umfasst.

## Claims

1. Light-emitting module (20) of terrestrial vehicle comprising:
- at least one semiconductor light source including a mostly semiconductor material substrate (21), the substrate having a first face and a second face, the light source further including electroluminescent elements (22) with submillimeter dimensions extending from the first face of the substrate; and
- at least one heatsink (28) cooperating with the second face of the substrate to evacuate the heat produced by the light source
**characterized in that**:
- the substrate is supplied with electricity via a printed circuit (24), the printed circuit board (24) skirting the substrate (21);
- the heatsink (28) is arranged against the second face of the substrate (21) via an intermediate element (32-34) that comprises one or more electronic control devices.

2. Light-emitting module according to claim 1, in which the semiconductor material includes silicon.

3. Light-emitting module according to claim 1 or 2, in which the electroluminescent elements are distributed in different selectively activatable light emitting zones.

4. Light-emitting module (100, 110) according to any one of claims 1-3, in which the printed circuit board (124) is flexible.

5. Light-emitting module according to any one of claims 1-4, in which the intermediate element comprises a thermal paste.

6. Light-emitting module according to any one of claims 1-5, in which the intermediate element comprises a layer of copper.

7. Light-emitting module according to any one of claims 1-6, in which the light source is glued or welded to the heatsink.

8. Light-emitting module according to any one of claims 1-7, further comprising an electronic device able to control the electroluminescent elements.

9. Light-emitting module according to any one of claims 1-8, in which the electronic device comprises at least one power converter and/or one integrated circuit.

10. Light-emitting module (80) according to any one of claims 1-9, in which the heatsink (28) comprises one or more finned radiators.

11. Light-emitting module (80) according to any one of claims 1-10, further comprising a heat distribution system integrated into the substrate.

12. Light-emitting module according to claim 11, in which the heat distribution system comprises one or more microheatpipes (82).

13. Light-emitting device (80-85, 90-95), notably for lighting and/or signaling, preferably in a terrestrial vehicle, comprising a light-emitting module according to any one of claims 1-12.
